Europäisches Patentamt

European Patent Office

Office européen des brevets

(11) Veröffentlichungsnummer: **0 561 416 A2**

## EUROPÄISCHE PATENTANMELDUNG

(21) Anmeldenummer: **93104532.2**

(22) Anmeldetag: **19.03.93**

(51) Int. Cl.5: **H03M 1/22**

(30) Priorität: **20.03.92 DE 4208918**

(43) Veröffentlichungstag der Anmeldung:
**22.09.93 Patentblatt 93/38**

(84) Benannte Vertragsstaaten:
**AT BE CH DE ES FR GB GR IT LI NL SE**

(71) Anmelder: **SIEMENS AKTIENGESELLSCHAFT**
**Wittelsbacherplatz 2**
**D-80312 München(DE)**

(72) Erfinder: **Schewe, Herbert, Dr.**
**Haydnstrasse 58**
**W-8522 Herzogenaurach(DE)**
Erfinder: **Burger, Wilhelm**
**Krähenweg 47**
**W-8510 Fürth-Burgfarrnbach(DE)**
Erfinder: **Cuylen, Michael**
**Kantstrasse 69**
**W-8502 Zirndorf(DE)**

(54) **Dreh- und Linearpositionsgebereinrichtung für ein bewegliches Geräteteil.**

(57) Die Positionsgebereinrichtung enthält einen Codeträger (2) mit einem Magnetisierungsmuster (m*), das in mehreren Spuren ($S_n$) positionsabhängige Magnetisierungsabschnitte (A1, A2) und in einer weiteren, inkrementalen Spur (S1) magnetische Flußwechsel (A3) aufweist. Erfindungsgemäß soll der Codeträger (2) mit einer vertikal orientierten magnetischen Speicherschicht (4) versehen sein, in welche zusätzlich das Magnetisierungsmuster einer Hilfsspur (S2) eingeschrieben ist. Dieses Magnetisierungmuster der Hilfsspur soll aus zumindest annähernd äquidistanten magnetischen Flußwechseln hoher Dichte gebildet sein.

FIG 1

EP 0 561 416 A2

Die Erfindung bezieht sich auf eine Dreh- oder Linearpositionsgebereinrichtung, welche einen mit einem beweglichen Teil eines Gerätes starr verbundenen Codeträger mit einem Codemuster in Form eines entsprechenden Magnetisierungsmusters enthält, das in mehreren Spuren der jeweiligen Position des beweglichen Teils zuzuordnende Magnetisierungsabschnitte und in mindestens einer weiteren, inkrementalen Spur magnetische Flußwechsel aufweist, wobei die Magnetisierungsabschnitte in den Spuren zur Positionsinformation jeweils in zwei nebeneinanderliegende Teilabschnitte mit unterschiedlicher Magnetisierung unterteilt sind. Der Positionsgebereinrichtung sind ferner mehrere Magnetfeldsensoren zum Auslesen des Magnetisierungsmusters zugeordnet. Eine derartige Positionsgebereinrichtung geht aus der US-PS 4 599 561 hervor.

Mit Drehpositionsgebern, die auch als Dreh- oder Winkelschrittgeber, Drehmeßwertaufnehmer oder Drehwinkeldecodierer bezeichnet werden, lassen sich allgemein bei einer drehenden Bewegung eines Geräteteils, z.B. eines Maschinenteils, vom Drehwinkel abhängige elektrische Meßsignale gewinnen. Auch für Geräte mit linearbeweglichen Teilen sind entsprechende Positionsgeber zu einer von der Linearposition abhängigen Meßsignalerzeugung entwickelt worden.

Ein aus der Siemens-Veröffentlichung "Inkrementale Drehgeber" bekannter Winkelschrittgeber enthält eine an einem drehbeweglichen Maschinenteil zu befestigende Scheibe aus Glas als Codeträger, auf der ein Codemuster in Form von sich in konzentrisch umschließenden Spuren befindlichen Radialstrichen (oder -segmenten) ausgebildet ist. Dieses Muster wird optoelektronisch abgetastet, indem das Licht mindestens einer Lichtquelle durch die transparenten Segmente der Codescheibe auf eine Vielzahl von Photodioden als Detektorenfeld, die jeweils einer bestimmten Spur der Codescheibe zugeordnet sind. Das Codemuster ist dabei so gewählt, daß mit Hilfe der Detektoren und einer ihnen zugeordneten Elektronik eine eindeutige Aussage über den Absolutwert des Drehwinkels bezüglich einer vorgegebenen Bezugslage möglich ist. Es hat sich jedoch gezeigt, daß bei einer solchen optischen Abtastung des Strichmusters Verschmutzungen der Codescheibe z.B. aufgrund von Schmiermitteln oder Flüssigkeiten eine eindeutige Auswertung erschweren können. Außerdem besteht vielfach die Gefahr, daß aufgrund unvermeidlicher Vibrationen der rotierenden Teile die Lichtquellen vorzeitig ausfallen.

Solche Probleme sind bei Positionsgebern mit Codemustern in Form von entsprechenden Magnetisierungsmustern nicht gegeben. Um einen derartigen Positionsgeber handelt es sich auch bei der aus der eingangs genannten US-PS zu entnehmenden Einrichtung zur Bestimmung der relativen und absoluten Position eines beweglichen Teils eines Gerätes, insbesondere der Welle eines bürstenlosen Dreiphasen-Wechselstrommotors. Dieser Motor enthält einen mitrotierenden, kreisscheibenförmigen Codeträger, dessen Flachseite mit konzentrischen Spuren aus magnetischem Material versehen ist. Am Außenrand des Codeträgers ist eine Spur zur inkrementalen Detektion (vgl. "Sensor Report", Heft 3, 1989, Seiten 6 und 7) sehr kleiner Winkeländerungen vorgesehen. Diese inkrementale Spur ist aus in Umfangsrichtung hintereinanderliegenden, gleichlangen Magnetisierungsabschnitten mit alternierender magnetischer Polarität gebildet. Es ergeben sich so äquidistante Magnetflußwechsel. Jeder Wechselstromphase ist zur Postitionsinformation eine Spur aus jeweils vier, ebenfalls gleichlangen Magnetisierungsabschnitten zugeordnet, die untereinander durch entsprechend lange, nicht-magnetische Bereiche beabstandet sind. Jeder dieser Magnetisierungsabschnitte ist dabei in zwei nebeneinanderliegenden Teilabschnitten mit entgegengesetzter Magnetisierung unterteilt. Mit dieser Ausgestaltung der bekannten Drehpositonsgebereinrichtung ist eine Überwachung der Phasenlage des Motors möglich. Jedoch können mit dieser Einrichtung weitere Informationen, insbesondere hinsichtlich des Vorzeichens der Drehrichtung ihres Codeträgers oder bezüglich des Absolutwertes des Drehwinkels bei einem Stillstand des Codeträgers nicht gewonnen werden.

Aufgabe der vorliegenden Erfindung ist es deshalb, die Drehpositonsgeber- bzw. entsprechende Linearpositionsgebereinrichtung mit den eingangs genannten Merkmalen dahingehend auszugestalten, daß mit ihr eine eindeutige Aussage über die absolute Position sowohl bei hohen Geschwindigkeiten als auch bei einem Stillstand des beweglichen Geräteteils ermöglicht ist. Zugleich sollen die mit einer optoelektronischen Abtastung verbundenen Funktionsstörungen unterdrückt sein. Die Dreh- oder Linearpositonsgebereinrichtung soll dabei einen inkrementalen und/oder absoluten Positionsgeber darstellen. Außerdem soll eine hohe Positionsgenauigkeit der Magnetisierungsabschnitte zu gewährleisten sein.

Diese Aufgabe wird erfindungsgemäß dadurch gelöst, daß der Codeträger mit einer magnetisierbaren, eine vertikalorientierte Vorzugsrichtung der Magnetisierung aufweisenden Speicherschicht versehen ist, in welche zusätzlich das Magnetisierungsmuster mindestens einer Hilfsspur eingeschrieben ist, die von einer Bezugsposition aus in Bewegungsrichtung des beweglichen Teils gesehen hintereinanderliegende, zumindest annähernd gleich weit beabstandete magnetische Flußwechsel enthält, deren Anzahl pro Ausdehnungseinheit in Bewegungsrichtung größer als die der inkrementalen Spur ist.

Prinzipiell sind zwar insbesondere Drehpositionsgebereinrichtungen mit drehbeweglichen Codeträgern bekannt, deren Codemuster in magnetisierbare Speicherschichten eingeschrieben sind (vgl. z.B. die DE-OS

2

29 08 599 oder 31 45 624). Bei diesen Codemustern setzen sich jedoch die Spuren zur Positionsinformation stets aus in Umfangsrichtung gleich langen Abschnitten mit alternierender Magnetisierung zusammen. Eine Unterteilung in zwei Teilspuren ist nicht vorgesehen. Gerade eine solche Unterteilung ermöglicht der erfindungsgemäßen inkrementalen und/oder absoluten Positionsgebereinrichtung, daß das magnetische Streufeld immer transversal bezüglich der jeweiligen Spur gerichtet und damit eindeutig auslesbar ist. Die damit verbundenen Vorteile sind also insbesondere darin zu sehen, daß an jedem Ort des Codeträgers in die Speicherschicht beliebig lange Magnetisierungsabschnitte einzuschreiben sind, die eine eindeutige Aussage bezüglich der jeweiligen absoluten Dreh- oder Linearposition ermöglichen. Auf dem Codeträger sind also Magnetisierungs- und damit Magnetfeldmuster quasi als ein Code einzuspeichern, die z.B. dem der optoelektronisch abzutastenden Codescheibe zumindest weitgehend entsprechen können. Wegen der vertikalen Vorzugsrichtung der Magnetisierung in der Speicherschicht können vorteilhaft hohe Dichten an Magnetflußwechseln geschrieben werden. Dies ist von besonderer Bedeutung für die zusätzliche Hilfsspur. Mit dieser Spur läßt sich ein absoluter Maßstab mit höchster Auflösung schaffen, der beim Einschreiben des Codes eine entsprechend genaue Position der Magnetisierungsabschnitte zur Positionsinformation und der Magnetflußwechsel der inkrementalen Spur gewährleistet. Eine hohe Auflösung der Hilfsspur läßt sich nämlich dadurch erreichen, daß man diese Spur mit einem von der Speicherschicht nur sehr gering beabstandeten Schreibelement beschreibt. In Abhängigkeit von dem so in die Hilfsschicht geschriebenen Magnetisierungsmuster lassen sich dann die anderen Spuren mit entsprechend hoher Positionsgenauigkeit in die Speicherschicht schreiben bzw. codieren. Beim Auslesen des so erzeugten Codes mit im allgemein deutlich weiter beabstandeten Magnetfeldsensoren bleibt die Magnetisierung der Hilfsspur unbeachtet. Das magnetische Einspeisen der Informationen und das Auslesen der gespeicherten Informationen erfolgt induktiv mit bekannten Schreib- bzw. Leseelementen und ist vorteilhaft wenig störungsanfällig. Zum Auslesen können vorzugsweise magnetoresistive Sensoren vorgesehen werden, wie sie insbesondere von magnetischen Plattenspeichern mit hoher Speicherdichte her bekannt sind.

Vorteilhafte Ausgestaltungen der erfindungsgemäßen Positionsgebereinrichtung gehen aus den Unteransprüchen hervor.

Die Erfindung wird nachfolgend anhand der schematischen Darstellungen der Zeichnung noch weiter erläutert. Dabei zeigt Figur 1 einen Ausschnitt aus einer erfindungsgemäß gestalteten Codescheibe einer Drehpositionsgebereinrichtung. Aus Figur 2 ist der prinzipielle Aufbau dieser Scheibe ersichtlich. In Figur 3 ist ein Stück einer magnetisierten Spur der Scheibe wiedergegeben. In Figur 4 sind drei Spuren dieser Scheibe näher veranschaulicht. Aus den Figuren 5 und 6 gehen Einzelheiten der Hilfsspur der erfindungsgemäßen Einrichtung hervor. In den Figuren sind sich entsprechende Teile mit denselben Bezugszeichen versehen. Nicht dargestellte Teile der erfindungsgemäßen Positonsgebereinrichtungen sind allgemein bekannt.

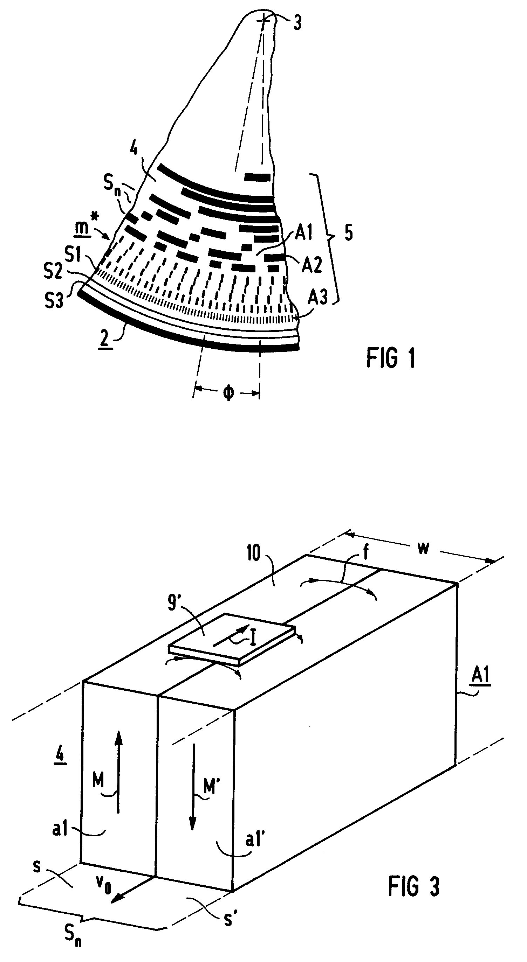

Dem Ausführungsbeispiel nach Figur 1 ist eine Drehpositonsgebereinrichtung, beispielsweise ein Winkelschrittgeber, zugrundegelegt. Von ihrer in der Figur in Aufsicht gezeigten, allgemein mit 2 bezeichneten Codescheibe (oder Code-Speicherplatte) ist nur ein sektorförmiger Abschnitt ersichtlich. Sie stimmt in großen Teilen mit einer Codescheibe überein, die Gegenstand der DE-Patentanmeldung P 40 30 450.7 vom 26.9.1990 ist. Die dargestellte Codescheibe 2 läßt sich an einem drehbeweglichen Teil eines maschinellen Gerätes, beispielsweise an der Geberwelle eines Stellmotors eines Roboters, so befestigen, daß ihre Achse 3 und die Drehachse zumindest annähernd zusammenfallen. Für die Codescheibe ist vorteilhaft ein spezielles Codierungsverfahren vorgesehen. Dieses Verfahren kann entsprechend auch zur Codierung von Linearpositionsgebereinrichtungen vorgesehen werden. Die Codescheibe 2 besteht im wesentlichen aus einer kreisscheibenförmigen Platte aus einem nicht-magnetischen Material, beispielsweise aus einem Glassubstrat. Diese als Codeträger dienende Platte ist erfindungsgemäß mit einem magnetisierbaren Aufzeichnungs- oder Speichermedium 4 beschichtet, wie es von der Datenspeichertechnik nach dem sogenannten vertikalen Magnetisierungsprinzip allgemein bekannt ist (vgl. z.B. "IEEE Trans. Magn.", Vol. MAG-16, No. 1, Januar 1980, Seiten 71 bis 76 und Vol. MAG-20, No. 5, September 1984, Seiten 657 bis 662 und 675 bis 680). Beispielsweise besteht das magnetisierbare Aufzeichnungsmedium 4 aus einer weichmagnetischen NiFe-Unterschicht, auf der eine vertikal magnetisierbare CoCr-Schicht aufgebracht ist. Beide Schichten sind etwa 0,5 $\mu$m dick. Die Koerzitivfeldstärke $H_{ci}$ der CoCr-Schicht beträgt mindestens 60 kA/m, vorzugsweise mehr als 80 kA/m. Selbstverständlich können für das magnetisierbare Medium auch andere magnetische Speichermaterialien vorgesehen werden.

Die Codierung des magnetischen Aufzeichnungsmediums 4 in Form eines entsprechenden Magnetisierungsmusters m* kann in weitgehender Analogie zu den bekannten optischen Codeverfahren mittels mindestens eines entsprechenden Magnetkopfes erfolgt sein. Dementsprechend sind in das Medium in einem mittleren, verhältnismäßig breiten Scheibenbereich 5 eine Vielzahl n von sich konzentrisch umschließenden Spuren $S_n$ mit streifenförmigen Magnetisierungsabschnitten A1 bzw. A2 eingeschrieben. Diese Magnetisierungsabschnitte zeichnen sich durch unterschiedliche Richtungen ihrer oberhalb der Platte auftretenden Magnetfelder transversal zur Spurrichtung aus. Gemäß der Darstellung der Figur sei beispielsweise angenommen, daß das von den hellen streifenförmigen Magnetisierungsabschnitten A1 erzeugte Magnetfeld radial nach dem Mittelpunkt der Platte hin verlaufen soll, während es in den dunkleren streifenförmigen Magnetisierungsabschnitten A2 entgegengerichtet ist. Die Spuren $S_n$ mit solchen Abschnitten werden auch als Absolutspuren bezeichnet. Sie dienen in erster Linie zu einer Information bzgl. der konkreten Position des beweglichen Teils der Maschine.

Wie insbesondere auch aus der Aufsicht der Figur 2 zu entnehmen ist, umschließt den Scheibenbereich 5 mit den Absolutspuren $S_n$ mindestens eine Inkrementalspur S1. Diese Spur weist in Umfangsrichtung gesehen zumindest weitgehend regelmäßig verteilte Magnetflußwechsel A3 (vgl. Figur 1) auf, die für eine hohe Winkelauflösung beim Auslesen der Magnetisierungsabschnitte A1, A2 erforderlich sind. Beispielsweise können zwei konzentrische Inkrementalspuren zur Erzeugung von zwei phasenverschobenen Signalen vorgesehen werden, um eine Feinauflösung zu verbessern. Erfindungsgemäß soll die mindestens eine Inkrementalspur S1 von einer Hilfsspur S2 umschlossen sein, deren in den Figuren 1 und 2 nicht näher ausgeführten magnetischen Flußwechsel (A4) von einer Bezugsposition aus in Umfangsrichtung gesehen hintereinanderliegen und jeweils annähernd gleiche, so geringe Abstände haben, daß auf jeden Flußwechsel A3 der Inkrementalspur S1 mehrere, beispielsweise mehr als vier Flußwechsel A4 der Hilfsspur S2 fallen. Diese Hilfsspur ermöglicht wegen der vergleichsweise wesentlich höheren Dichte, d.h. Zahl von Flußwechseln A4 pro Ausdehnungseinheit in Umfangsrichtung als in der Inkrementalspur S1 ein entsprechend exaktes Positionieren der Magnetisierungsabschnitte A1, A2. In Randnähe der Codescheibe 2 kann gegebenenfalls noch eine Indexspur S3 vorgesehen sein, um die erforderliche Bezugsposition für den Anfang einer Zählung der Flußwechsel A4 in der Hilfsspur S2 festzulegen. Hierzu sind in die Indexspur S3 Flußwechsel geschrieben, die einen Index, d.h. im Falle der drehbeweglichen Codescheibe 2 einen festen Wert des Drehwinkel $\phi$, z.B. $\phi = 0$, der Scheibe definieren. Die in der Figur angedeutete Folge von unterschiedlich langen Intervallen zwischen den in diese Spur S3 geschriebenen Pulsen ist für eine eindeutige Erkeinbarkeit des Indexpulses P als Bezugspositon von Vorteil. Falls ein Indexpuls von der Antriebsachse 3 der Scheibe abzuleiten ist, kann auf die Indexspur S3 verzichtet werden.

Wie aus Figur 2 hervorgeht, werden für die Code-Speicherplatte 2 mindestens zwei, im Falle des Vorhandenseins einer Indexspur S3 drei Magnetfeldsensoren 7 bis 9 verwendet. Als Magnetfeldsensoren können übliche Dünnfilm-Magnetköpfe eingesetzt werden, wie sie z.B. für das sogenannte longitudinale oder vertikale Magnetisierungsprinzip bekannt sind. Diese Magnetköpfe können aerodynamisch mit einer Flughöhe von beispielsweise 0,1 bis 0,3 $\mu$m über dem Aufzeichnungsmedium 4 hinweggleiten. Die Köpfe 7 und 8 zum Schreiben und Lesen der Indexspur S3 und der Hilfsspur S2 sind jeweils ortsfest auf einem vorbestimmten Radius angeordnet. Der weitere Kopf 9 dient zum Schreiben der mindestens einen Inkrementalspur S1 und der Absolutspuren $S_n$. Es können auch 2 Köpfe für die Inkrementalspur und die Absolutspuren vorgesehen werden. Diese Absolutspuren sollen jeweils aus Zwei Teilspuren entgegengesetzter Magnetisierung bestehen. Ihnen können wegen der verhältnismäßig weit ausgedehnten Magnetisierungsabschnitte bzw. wegen der verhältnismäßig kleinen Bitdichte insbesondere Magnetköpfe 9 nach dem longitudinalen Magnetisierungsprinzip zugeordnet werden Zum Auslesen der Absolutspuren $S_n$ dienen besondere, vorzugsweise nicht-induktive Magnetfeldsensoren.

Figur 3 zeigt einen Informationsabschnitt, beispielsweise einen Magnetisierungsabschnitt A1, einer Absolutspur $S_n$ in Schrägansicht. Diese Spur mit einer Weite w ist in zwei nebeneinanderliegende Teilspuren s und s' mit jeweils gleicher Weite w/2 unterteilt. Der Magnetisierungsabschnitt A1 setzt sich deshalb aus zwei nebeneinanderliegenden Teilabschnitten a1 und a1' zusammen. Dabei sollen diese beiden Teilabschnitte so magnetisiert sein, daß in ihnen die Magnetisierung M bzw. M' entgegengesetzt gerichtet verläuft. Wegen dieser Magnetisierungsrichtungen M und M' in den Teilspuren s und s' ruft der Magnetisierungsabschnitt A1 ein Magnetfeld bzw. ein magnetisches Streufeld mit einem Fluß hervor, der radial, d.h. quer zur Längsrichtung der Spur $S_n$ gerichtet ist. Von diesem Magnetfeld sind in Figur 3 einige Feldlinien f veranschaulicht. Das Feld wird mittels mindestens einer bekannten magnetfeldsensitiven Auslesevorrichtung wie z.B. einem geeigneten Magnetkopf 9' ausgelesen. Besonders geeignet hierfür ist auch ein allgemein bekannter magnetoresistiver Sensor, der gemäß dem dargestellten Ausführungsbeispiel mit seiner Flachseite parallel zur Oberfläche 10 des Magnetisierungsabschnittes A1 bzw. der Codescheibe längs der Spur $S_n$ relativ geführt wird. Die Codescheibe dreht sich mit einer relativen Geschwindigkeit $v_o$ der Spur $S_n$ bezüglich dieses Sensors unter diesem hinweg. In dem in das Magnetfeld mit den Feldlinien f eingebrachten magnetoresistiven Sensor 9' wird ein durch eine gepfeilte Linie dargestellter Strom I erzeugt, der eine eindeutige Aussage über die Magnetisierungsverhältnisse in dem Abschnitt A1 ermöglicht.

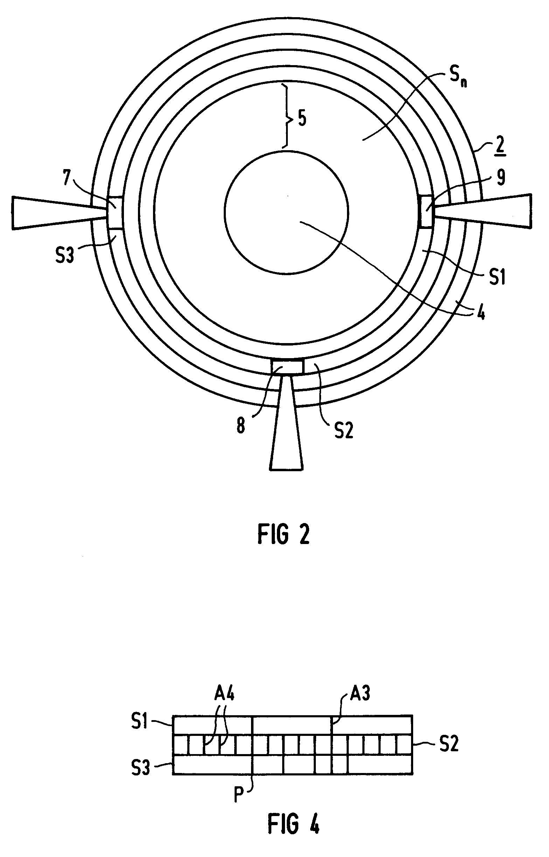

Nachfolgend ist eine Codierung der Codescheibe 2 unter Bezugnahme auf die Figuren 4 bis 6 erläutert. Wie aus dem in Figur 4 veranschaulichten Ausschnitt aus den Spuren S1, S2 und S3 wird auf der Hilfsspur S2, getriggert durch einen Indexpuls P der Indexspur S3, ein Muster von möglichst äquidistanten Magnetflußwechseln A4 in Form von Bits beschrieben. Die Bitlänge, d.h. der Abstand von zwei Magnetflußwechseln, soll dabei einen Sollwert $a_o$ aufweisen. Die Winkelauflösung auf der Hilfsspur S2 wird dann durch die Anzahl N der Pulse pro Umdrehung der Scheibe bestimmt und ist um ein Vielfaches, beispielsweise 10 bis 100 mal höher als die Auflösung der Inkrementalspur S1 der Codescheibe 2. Bei einem vorgegebenen Durchmesser $d_o$ auf der Scheibe und festgelegter Drehzahl z (in Hertz) erhält man für die Relativgeschwindigkeit $v_o$ zwischen einem der Magnetköpfe 7 bis 9 und der Scheibe:

$$v_o = \pi * z * d_o.$$

Die Schreibfrequenz $f_o$ ist dann gegeben durch:

$$f_o = \frac{v_o}{(2 * a_o)} \quad .$$

Mit dem beschriebenen Verfahren kann also mittels der Hilfsspur S2 ein Maßstab auf die Codescheibe geschrieben werden, der durch Abzählen der Pulse nach dem Auftreten eines Indexpulses P eine sehr genaue Absolutcodierung der Codescheibe ermöglicht.

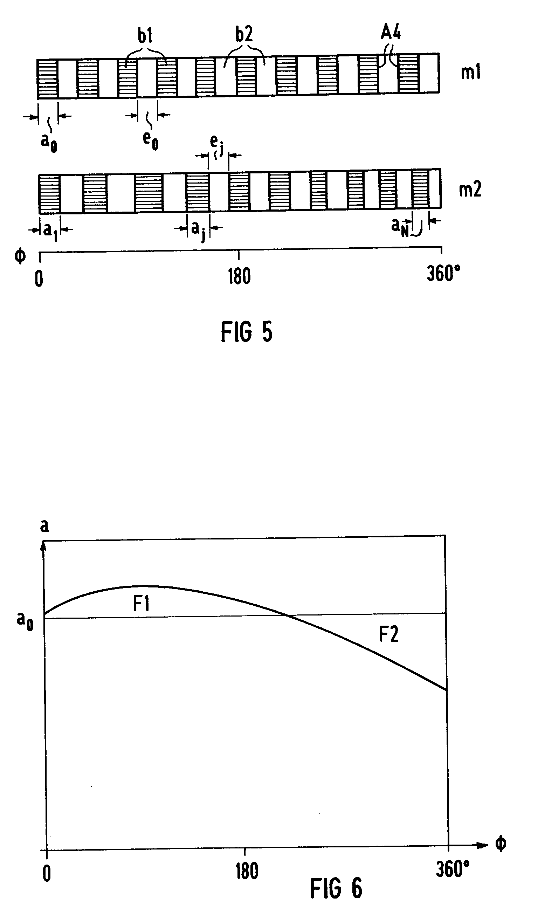

Um dieses Verfahren auch bei sehr hohen Anforderungen an die Winkelauflösung einsetzen zu können, muß gegebenenfalls berücksichtigt werden, daß wegen unvermeidbarer Gleichlaufschwankungen einer Antriebsspindel oder -welle der Codescheibe 2 die Drehzahl z nicht genau einzuhalten ist und auch die Frequenz $f_0$ eines Schreiboszillators etwas schwanken kann. Dieser Sachverhalt ist in den Figuren 5 und 6 veranschaulicht. Das in Figur 5 gezeigte erste Bitmuster ml stellt den Idealfall dar, daß die Magnetflußwechsel A4 der Hilfsspur S2 völlig gleichmäßig und äquidistant über den Umfang der Codescheibe 2 bzw. bezüglich des Drehwinkels $\phi$ (mit $0 \leq \phi \leq 360°$) angeordnet sind. Die Magnetflußwechsel sind dabei jeweils durch Übergänge zwischen Bereichen b1 und b2 mit unterschiedlichen Magnetisierungen erzeugt. Beispielsweise weist der Magnetisierungsbereich b1 eine vorbestimmte Magnetisierung auf, während ein dazu benachbarter Bereich b2 nicht oder entgegengesetzt magnetisiert ist. Jeder magnetisierte Bereich b1 hat die gleiche Ausdehnung $a_o$ und ist von dem jeweils nächsten Bereich b1 um eine entsprechende Strecke $e_o$ eines Bereichs b2 entfernt. Die Magnetflußwechsel A4 haben also einen gegenseitigen Abstand $a_o + e_o$. Abweichend von diesem Idealfall ergibt sich jedoch im allgemeinen ein zweites Bitmuster m2 mit unterschiedlichen Längen $a_j$ (mit $1 \leq j \leq N$) der Magnetisierungsbereiche b1 und damit auch der diese Bereiche beabstandenden Strecken $e_j$. Das heißt, die gegenseitigen Abstände $a_j + e_j$ benachbarter Flußwechsel sind dann nicht identisch mit der als ein Mittelwert $a_o + e_o$ nach Figur 4 anzusehenden Größe. Figur 6 gibt in einem Diagramm als Kurve die Variation der Bitlänge $a_j$ in Abhängigkeit von dem Drehwinkel $\phi$ der Codescheibe wieder. Hierbei sind die von der Mittelwert-Kurve mit der Geraden $a_j = a_o$ eingeschlossenen Flächen F1 und F2 zumindest annähernd gleich groß.

Um die durch die genannten Gleichlaufschwankungen und Frequenzfehler entstandenen fehlerhaften Bitlängen erkennen und korrigieren zu können, wird das auf dem Umfang der Codescheibe geschriebene Bitmuster der Hilfsspur S2 gemessen. Hierzu wird zunächst, getriggert durch einen Indexpuls P, die Anzahl der Pulse N, d.h. die Anzahl der geschriebenen magnetischen Übergänge während eines Umlaufs gezählt. Anschließend wird die Länge $a_j$ jedes geschriebenen Magnetisierungsbereichs b1 (Bits) bestimmt. Gemessen wird die Zeit zwischen zwei Pulsen. Ein Umlauf entspricht dabei einem Winkel von 360°.

Es gilt für die jeweilige Bitlänge $a_j$:

$a_j = a_o + \Delta a_j$ für $j = 1 ... N$.

Durch Messung der Winkel $a_j$ erhält man einen Maßstab, der im Rahmen der vorgegebenen Toleranz eine ausreichend genaue Codierung der Inkremental- und Absolutspuren ermöglicht.

Es werden m Messungen durchgeführt. Dabei ergeben sich folgende gemessene Winkelwerte, die mit $a_{ij}$ (die Zahl i gibt die i-te Messung an und der Index j bezeichnet das j-te Bit) bezeichnet werden:

1. Messung $a_{11}, a_{12}, a_{13}, ..., a_{1N}$

2. Messung $a_{21}, a_{22}, a_{23}, ..., a_{2N}$

...

...

m-te Messung $a_{m1}, a_{m2}, a_{m3}, ..., a_{mN}$.

Es ist:

$$\sum_{j=1}^{N} a_{mj} = 360^{\circ}$$

für i = 1 ... m,
da ein voller Umlauf mit Hilfe des Indexpulses P eindeutig erkannt wird. Durch Gleichlaufschwankungen und Meßfehler bedingt, treten allerdings kleinere Abweichungen der einzelnen Meßwerte $a_{ij}$ auf.

Aus den Werten $a_{ij}$ können für jede Bitlänge mit dem Index j der Mittelwert $a_j$ und die Standardabweichung $_j$ berechnet werden:

$$a_j = \sum_{i=1}^{m} a_{ij}$$

für j = 1 ... N und:

$$\sigma_j^2 = (m-1)^{-1} * \sum_{i=1}^{m} (a_{ij} - a_o)^2$$

für j = 1 ... N.

Die Zahl der Messungen m kann hierbei solange erhöht werden, bis jede der Standardabweichungen $\sigma_i$ kleiner als ein vorgegebener Wert ist.

Eine weitere Überprüfung des Meßergebnisses kann mit Hilfe der Bedingung:

$$\sum_{i=1}^{m} a_j = 360^{\circ}$$

erfolgen.

Mit dem vorbeschriebenen Verfahren ist es also möglich, durch Abzählen der Pulse die genaue Winkelposition anzugeben, und man erhält den gewünschten Maßstab, der allerdings nicht genau äquidistant unterteilt ist.

Drei konkrete Ausführungsbeispiele sind in der folgenden Tabelle angegeben. Dabei ist davon ausgegangen, daß die Drehzahl 3200 Upm beträgt, der Durchmesser der Hilfsspur S2 $d_o$ = 45,837 mm ist und die Relativgeschwindigkeit sich zu $v_o$ = 7,68 m/s ergibt.

Tabelle

| Hilfsspur S2 | Beispiel 1 | Beispiel 2 | Beispiel 3 |
|---|---|---|---|
| Pulse/Umdrehung | 22.500 | 45.000 | 90.000 |
| Bitlänge $a_o$ [$\mu$m] | 6,4 | 3,2 | 1,6 |
| Flußwechseldichte [kfci] | 3,97 | 7,94 | 15,88 |
| Schreibfrequenz $f_o$[MHz] | 0,6 | 1,2 | 2,4 |

Die Codierung der entsprechenden Winkelschrittgeber mit einer Auflösung von z.B. 2.250 Pulsen/Umdrehung (Beispiel 1) ergibt mit obigen Daten eine Bitlänge auf der Inkrementalspur S1 von 64 $\mu$m. Mit Hilfe des Maßstabs auf der Hilfsspur S2 läßt sich dieses Muster mit hoher Genauigkeit in die Codescheibe einschreiben. Das Auslesen der codierten Information kann mit magnetoresistiven Sensoren erfolgen, die sich im Abstand von 50 $\mu$m über der Codespur befinden. Im Beispiel 1 ist die Auflösung auf der Hilfsspur um einen Faktor 10 höher und in den Beispielen 2 bzw. 3 sogar um einen Faktor 20 bzw. 40 besser.

Für die in den Figuren dargestellten Ausführungsbeispiele zur Erläuterung der Erfindung wurde von einer Positionsgebereinrichtung ausgegangen, deren Codeträger kreisscheibenförmig ausgeführt ist und mit einem drehbeweglichen Teil eines maschinellen Gerätes starr verbunden wird. Das auf der Codescheibe dieser Drehpositionsgebereinrichtung eingeschriebene magnetische Codemuster ist deshalb vom jeweiligen Drehwinkel des drehbeweglichen Teils des maschinellen Gerätes abhängig. Selbstverständlich sind die dargestellten Maßnahmen auch auf Linearpositionsgebereinrichtungen übertragbar. Eine entsprechende Linearpositionsgebereinrichtung enthält dann einen mit einem linear beweglichen Teil eines maschinellen Gerätes starr verbundenen Codeträger, auf welchem in sich linear erstreckenden Spuren einer magnetischen Speicherschicht ein magnetisches Codemuster eingeschrieben ist, dessen Struktur aus Informationen von der jeweiligen linearen Position des linear beweglichen Teils des Gerätes abhängig ist. Dabei kann das erläuterte Codierungsverfahren, wenn man statt der Drehbewegung eine Linearbewegung vorsieht, direkt auf den Fall der Codierung von Linearpositionsgebereinrichtungen übertragen werden.

## Patentansprüche

1. Dreh- oder Linearpositionsgebereinrichtung,
   - welche einen mit einem beweglichen Teil eines Gerätes starr verbundenen Codeträger mit einem Codemuster in Form eines entsprechenden Magnetisierungsmusters enthält, das in mehreren Spuren von der jeweiligen Position des beweglichen Teils zuzuordnende Magnetisierungsabschnitte und in mindestens einer weiteren, inkrementalen Spur magnetische Flußwechsel aufweist, wobei die Magnetisierungsabschnitte in den Spuren zur Positionsinformation jeweils in zwei nebeneinanderliegende Teilabschnitte mit unterschiedlicher Magnetisierung unterteilt sind,
   
   und
   - der mehrere Magnetfeldsensoren zum Auslesen des Magnetisierungsmusters zugeordnet sind,
   
   **dadurch gekennzeichnet,** daß der Codeträger (2) mit einer magnetisierbaren, eine vertikal orientierte Vorzugsrichtung der Magnetisierung (M, M') aufweisenden Speicherschicht (4) versehen ist, in welche zusätzlich das Magnetisierungsmuster (m1, m2) mindestens einer Hilfsspur (S2) eingeschrieben ist, die von einer Bezugsposition (P) aus in Bewegungsrichtung ($v_o$) des beweglichen Teils gesehen hintereinanderliegende, zumindest annähernd gleich weit beabstandete magnetische Flußwechsel (A4) enthält, deren Anzahl pro Ausdehnungseinheit in Bewegungsrichtung größer als die der inkrementalen Spur (S1) ist.

2. Gebereinrichtung nach Anspruch 1, **dadurch gekennzeichnet,** daß die Dichte der Flußwechsel (A4) der Hilfsspur (S2) mindestens um das Vierfache größer als die Dichte der Flußwechsel (A3) der inkrementalen Spur (S1) ist.

3. Gebereinrichtung nach Anspruch 1 oder 2, **dadurch gekennzeichnet,** daß als Magnetfeldsensoren zum Auslasen des Magnetisierungsmusters (m*) magnetoresistive Sensoren (9') vorgesehen sind.

4. Gebereinrichtung nach Anspruch 3, **gekennzeichnet durch** magnetoresistive Sensoren (9'), deren Flachseiten senkrecht zur Magnetisierungsrichtung (M, M') in der Speicherschicht (4) ausgerichtet sind (vgl. Figur 3).

5. Gebereinrichtung nach einem der Ansprüche 1 bis 4, **dadurch gekennzeichnet,** daß die Speicherschicht (4) auf einer Unterschicht aus einer weichmagnetischen NiFe-Legierung angeordnet ist.

6. Gebereinrichtung nach einem der Ansprüche 1 bis 5, **dadurch gekennzeichnet,** daß eine Indexspur (S3) zur Erzeugung eines einen Indexpuls (P) als Bezugsposition definierenden Magnetisierungsmusters vorgesehen ist.

7. Gebereinrichtung nach einem der Ansprüche 1 bis 6, **gekennzeichnet durch** Korrekturmittel, mit denen Abweichungen des gegenseitigen Abstandes ($a_i + e_i$) von benachbarten Flußwechseln (A4) in der Hilfsspur (S2) von einem Mittelwert ($a_o + e_o$) des Abstandes zu korrigieren sind.

FIG 1

FIG 3

8

FIG 2

FIG 4

FIG 5

FIG 6